# FASCICULE DE BREVET EUROPEEN

(11) **EP 2 582 859 B1**
(45) Date de publication et mention de la délivrance du brevet: **06.08.2014**
(21) Numéro de dépôt: 11734164.4
(22) Date de dépôt: 10.06.2011
(51) Int. Cl.: C23C 10/28, B05D 1/36, C25D 3/12, C25D 5/12, C25D 5/40, C23C 16/02, C23C 16/06, C23C 28/02

(54) **PROCEDE D'ALUMINISATION D'UNE SURFACE AVEC DEPOT PREALABLE D'UNE COUCHE DE PLATINE ET DE NICKEL**
VERFAHREN ZUR ALUMINIERUNG EINER OBERFLÄCHE MITTELS VORABSCHEIDUNG EINER PLATIN- ODER NICKELSCHICHT
METHOD FOR ALUMINIZING A SURFACE BY MEANS OF THE ADVANCE DEPOSITION OF A PLATINUM AND NICKEL LAYER

(30) Priorité: 18.06.2010 FR 1054850
(43) Date de publication de la demande: 24.04.2013
(73) Titulaire: Snecma, 75015 Paris (FR)
(72) Inventeur: LAGRANGE, Frédéric, F-87170 Avanton (FR); MANESSE, Denis, F-86100 Chatellerault (FR)
(74) Mandataire: Berbinau, Pierre Jean Marie
(86) Numéro de dépôt international: PCT/FR2011/051330
(87) Numéro de publication internationale: WO 2011/157935

(56) Documents cités:
- EP-A1- 1 254 967
- EP-A2- 1 528 118
- FR-A1- 2 924 129

## Description

La présente invention concerne un procédé de dépôt d'un revêtement d'aluminisation sur un substrat.

On utilise des revêtements à base d'aluminium, dits "revêtements d'aluminisation", pour protéger la surface de pièces opérant à haute température et dans des environnements oxydants. Un tel revêtement peut également servir de couche d'accroche à un autre revêtement protecteur, ce revêtement protecteur étant plus apte à adhérer à un tel revêtement d'aluminisation qu'à la surface de la pièce elle-même.

Par exemple, de telles pièces se trouvent dans les turbomachines aéronautiques telles que des moteurs d'avion. Ces pièces sont notamment des aubes ou des distributeurs de turbines.

Ces pièces sont par exemple fabriquées en superalliages base nickel.

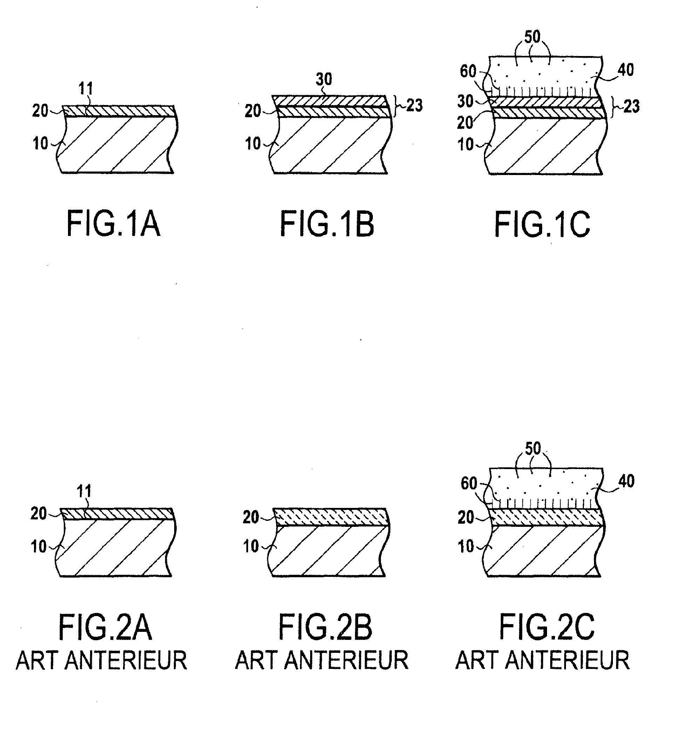

Pour effectuer un revêtement d'aluminisation sur un tel superalliage, on dépose tout d'abord une couche de platine 20 sur la surface 11 de ce superalliage qui est le substrat 10. Cette étape est illustrée en figure 2A.

Puis on effectue un traitement thermique de diffusion destiné à faire diffuser le nickel du superalliage 10 dans la couche de platine 20, et également le platine dans le superalliage 10. Cette étape est illustrée en figure 2B. Cette diffusion permet ainsi d'amener du nickel vers la surface libre de la couche de platine 20. Cette diffusion s'effectue dans une enceinte sous vide et à haute température, par exemple à 1100°C pendant deux heures.

On effectue ensuite un traitement thermochimique d'aluminisation qui conduit au dépôt d'une couche d'aluminium 40 sur la couche de platine 20. Cette étape est illustrée en figure 2C. Suite à ce dépôt, il se forme dans la couche d'aluminium 40 des composés PtAl₂ 50 qui sont dispersés dans cette couche d'aluminium. L'étape de diffusion est indispensable pour empêcher la formation en grande quantité de PtAl₂ qui se regroupe alors pour former en surface de la couche d'aluminium 40 des plaques qui diminuent l'efficacité de la protection. En effet, grâce à cette étape de diffusion, le nickel qui a diffusé dans la couche de platine 20 diffuse dans la couche d'aluminium 40 où il forme des composés NiAl 60, ce qui réduit la formation de PtAl₂ et donc le risque de formation de plaques de PtAl₂ à la surface de la couche d'aluminium 40. Un procédé de dépôt d'un revêtement d'aluminisation selon l'art antérieur est par exemple décrit dans le document FR 2 924 129 A1.

L'inconvénient de ce procédé actuellement utilisé est que le traitement de diffusion de la couche de platine est long et couteux.

La présente invention vise à remédier à cet inconvénient. L'invention vise à proposer un procédé de dépôt d'un revêtement d'aluminisation sur un substrat dont le coût et la durée soient diminués par rapport au procédé actuel.

Ce but est atteint grâce au fait que le procédé comporte les étapes suivantes :
(a) On dépose une couche contenant du platine et au moins 35% de nickel sur une surface du substrat,
(b) On dépose un revêtement d'aluminium sur cette couche.

Alternativement, ce but est également atteint grâce au procédé comportant les étapes suivantes:
(a) on dépose tout d'abord sur une surface (11) dudit substrat (10) une première couche (20) contenant du platine puis, sur ladite première couche (20), une seconde couche (30) contenant du nickel de telle sorte que la couche de platine (20) et la couche de nickel (30) forment une couche (23) qui contient du platine et au moins 35% atomique de nickel.
(b) on dépose un revêtement d'aluminium (40) sur ladite couche (23).

Grâce à ces dispositions, la durée totale du procédé de dépôt du revêtement d'aluminisation est réduite, puisqu'il n'y a plus d'étape de diffusion. De plus, le coût total du procédé de dépôt du revêtement d'aluminisation est diminué, car le dépôt d'un revêtement contenant du platine et du nickel peut être réalisé selon des procédés connus et peu onéreux.

L'invention sera bien comprise et ses avantages apparaîtront mieux, à la lecture de la description détaillée qui suit, d'un mode de réalisation représenté à titre d'exemple non limitatif. La description se réfère aux dessins annexés sur lesquels :
- les figures 1A, 1B, et 1C illustrent les étapes du procédé de dépôt d'un revêtement d'aluminisation selon l'invention,
- les figures 2A, 2B, et 2C illustrent les étapes du procédé de dépôt d'un revêtement d'aluminisation selon l'art antérieur.

Comme représenté schématiquement en figure 1A, on considère une pièce dont une partie ou la totalité de la surface doit être protégée par un revêtement d'aluminisation. Cette pièce constitue ainsi un substrat 10.

La couche 23 contenant du platine et au moins 35% de nickel est déposée sur la surface 11 du substrat 10. Ce dépôt peut être effectué par électrolyse, par exemple en trempant le substrat 10 dans un bain électrolytique contenant des sels de platine et des sels de nickel.

On décrit ci-dessous le mode de réalisation particulier où la couche 23 est composée d'une première couche 20 contenant du platine, et d'une seconde couche 30 contenant du nickel.

On dépose tout d'abord, de façon connue, par exemple par électrolyse, une couche de platine 20 (première couche) sur la surface 11 du substrat 10 (étape (a), figure 1A). Ainsi, on trempe le substrat 10 dans un bain électrolytique contenant des sels de platine, ce susbtrat jouant le rôle d'une électrode (cathode), et on fait passer un courant entre cette électrode et une autre électrode (anode) en platine. Le platine se dépose alors progressivement sur le substrat.

L'épaisseur de cette couche de platine est par exemple de l'ordre de 5 µm à 10 µm.

Préalablement, on peut éventuellement effectuer une préparation de cette surface 11 destinée à obtenir un meilleur accrochage de la couche de platine 20 sur cette surface 11. Cette préparation consiste par exemple à rendre cette surface plus rugueuse, les reliefs ainsi formés servant d'accroches pour la couche de platine 20.

Cette préparation de surface peut également être effectuée dans le cas plus général d'un dépôt de la couche 23 (composée d'une couche de platine 20 et d'une couche de nickel 30) sur la surface 11.

On n'effectue pas de traitement de diffusion de cette couche de platine 20.

Comme représenté schématiquement en figure 1B, on dépose sur la couche de platine 20 une couche de nickel 30 (seconde couche) (étape (b), figure 1B).

Le dépôt de cette couche de nickel 30 s'effectue par exemple par le procédé connu d'électrolyse. On trempe la pièce à recouvrir dans un bain électrolytique contenant des sels de nickel, cette pièce jouant le rôle d'une électrode (cathode), et on fait passer un courant entre cette électrode et une autre électrode (anode) en nickel. Le nickel se dépose alors progressivement sur pièce.

L'avantage du procédé selon l'invention est que le dépôt de la couche de platine 20 puis de la couche de nickel 30 peuvent être effectués consécutivement dans la même installation. Il en résulte donc un gain de temps. En outre, ces dépôts peuvent être effectués à basse température et à pression ambiante, ce qui est moins couteux que le traitement de diffusion utilisé dans l'art antérieur (étape illustrée en figure 2B), puisque ce traitement de diffusion doit être effectué sous vide à haute température.

On effectue ensuite le dépôt d'une couche 40 d'aluminium sur la couche de nickel 30 (étape (c), figure 1C). Ce dépôt s'effectue par exemple par le procédé de dépôt thermochimique d'aluminium en phase vapeur (Chemical Vapor Déposition ou CVD). On place le substrat 10 revêtu de la couche de platine 20 et de la couche de nickel 30 dans une enceinte, dans laquelle on injecte des atomes d'aluminium en phase gazeuse, ces atomes d'aluminium venant se déposer sur la couche de nickel 30. Ce dépôt s'effectue à haute température, par exemple à environ 1100°C pendant 6 heures.

Avantageusement, on établit préalablement un vide dans cette enceinte, par exemple en 400 millibars et 1100 millibars.

Ce vide permet d'améliorer la qualité du dépôt d'aluminium, en particulier l'uniformité de ce dépôt.

Grâce à la présence de la couche de nickel 30, les atomes de nickel diffusent directement depuis cette couche de nickel 30 dans la couche d'aluminium 40 où il forme des composés NiAl 60, ce qui réduit la formation de composés PtAl₂ 50 et donc le risque de formation de plaques de PtAl₂ à la surface de la couche d'aluminium 40.

De plus, la réduction de cette formation de PtAl₂ est plus efficace que dans le procédé selon l'art antérieur, car davantage d'atomes de nickel diffusent dans la couche d'aluminium 40. En effet, la couche de nickel 30, qui est en contact avec la couche d'aluminium 40, est composée de presque 100% de nickel dans le cas d'un dépôt par électrolyse.

D'une manière générale, la couche de nickel 30 contient suffisamment de nickel de telle sorte que la couche 23,qui est composée de la couche de platine 20 et de la couche de nickel 30 (ou d'une couche unique contenant du platine et du nickel) contient au moins 35% de nickel.

Au contraire, dans l'art antérieur, la couche en contact avec la couche d'aluminium 40 comprend à la fois des atomes de platine et des atomes de nickel. Or les diagrammes de phase Ni-Pt-Al montrent que les composés NiAl se forment au détriment des composés PtAl₂ d'autant plus facilement que la surface sur laquelle cette couche d'aluminium 40 est déposée comprend plus de 35% atomique de nickel.

En outre, contrairement au procédé selon l'art antérieur, il n'est pas nécessaire que le substrat 10 contienne du nickel, puisque l'apport de nickel destiné à diffuser dans la couche d'aluminium 40 provient de la couche de nickel 30 qui est déposée sur la couche de platine 20 qui a été déposée sur ce substrat 10. Le procédé selon l'invention peut donc être utilisé sur n'importe quel substrat 10, et pas seulement sur les superalliages base nickel. Par exemple le procédé selon l'invention peut être utilisé sur n'importe quel superalliage.

Après dépôt de la couche d'aluminium 40, il est possible de déposer sur cette couche un autre matériau, par exemple une barrière thermique en céramique lorsque la pièce ainsi revêtue est destinée aux applications hautes températures.

## Revendications

1. Procédé de dépôt d'un revêtement d'aluminisation sur un substrat (10) **caractérisé en ce qu'**il comporte les étapes suivantes :
(a) On dépose une couche (23) contenant du platine et au moins 35% atomique de nickel sur une surface (11) dudit substrat (10),
(b) On dépose un revêtement d'aluminium (40) sur ladite couche (23).

2. Procédé de dépôt d'un revêtement d'aluminisation sur un substrat (10) **caractérisé en ce qu'**il comporte les étapes suivantes:
(a) on dépose tout d'abord sur une surface (11) dudit substrat (10) une première couche (20) contenant du platine puis, sur ladite première couche (20), une seconde couche (30) contenant du nickel de telle sorte que la couche de platine (20) et la couche de nickel (30) forment une couche (23) qui contient du platine et au moins 35% atomique de nickel.
(b) on dépose un revêtement d'aluminium (40) sur ladite couche (23).

3. Procédé selon la revendication 2 **caractérisé en ce que**, à l'étape (a), ladite seconde couche (30) de nickel est déposée par électrolyse.

4. Procédé selon l'une quelconque des revendications 1 à 3 **caractérisé en ce que** ledit substrat (10) est un superalliage.

5. Procédé selon la revendication 4 **caractérisé en ce que** ledit superalliage est un superalliage base nickel.

6. Procédé selon l'une quelconque des revendications 1 à 5 **caractérisé en ce qu'**avant le dépôt de ladite couche (23) à l'étape (a), on effectue une préparation de ladite surface (11).

## Patentansprüche

1. Verfahren zum Abscheiden einer Aluminisierungsbeschichtung auf einem Substrat (10), **dadurch gekennzeichnet, dass** es die folgenden Schritte umfasst:
(a) eine Schicht (23), die Platin und wenigstens 35 at% Nickel enthält, wird auf einer Oberfläche (11) des Substrats (10) abgeschieden,
(b) eine Aluminiumbeschichtung (40) wird auf der Schicht (23) abgeschieden.

2. Verfahren zum Abscheiden einer Aluminisierungsbeschichtung auf einem Substrat (10), **dadurch gekennzeichnet, dass** es die folgenden Schritte umfasst:
(a) zunächst wird auf einer Oberfläche (11) des Substrats (10) eine Platin enthaltende erste Schicht (20), anschließend auf der ersten Schicht (20) eine Nickel enthaltende zweite Schicht (30) abgeschieden, derart, dass die Platinschicht (20) und die Nickelschicht (30) eine Schicht (23) bilden, die Platin und wenigstens 35 at% Nickel enthält,
(b) auf der Schicht (23) wird eine Aluminiumbeschichtung (40) abgeschieden.

3. Verfahren nach Anspruch 2, **dadurch gekennzeichnet, dass** bei Schritt (a) die zweite Schicht (30) aus Nickel durch Elektrolyse abgeschieden wird.

4. Verfahren nach einem der Ansprüche 1 bis 3, **dadurch gekennzeichnet, dass** das Substrat (10) eine Superlegierung ist.

5. Verfahren nach Anspruch 4, **dadurch gekennzeichnet, dass** die Superlegierung eine Nickelbasis-Superlegierung ist.

6. Verfahren nach einem der Ansprüche 1 bis 5, **dadurch gekennzeichnet, dass** vor dem Abscheiden der Schicht (23) bei Schritt (a) ein Präparieren der Oberfläche (11) vollzogen wird.

## Claims

1. A method for depositing an aluminizing coating on a substrate (10), **characterized in that** it includes the following steps:
(a) A layer (23) containing platinum and at least 35 atomic % of nickel is deposited on a surface (11) of said substrate (10),
(b) An aluminum coating (40) is deposited on said layer (23).

2. A method for depositing an aluminizing coating on a substrate (10), **characterized in that** it includes the following steps:
(a) a first layer (20) containing platinum is first deposited on a surface (11) of said substrate (10) and, then, a second layer (30) containing nickel is deposited on the first layer (20), so that the platinum layer (20) and the nickel layer (30) form a layer (23) comprising platinum and at least 35 atomic % of nickel.
(b) an aluminum coating (40) is deposited on said layer (23).

3. The method according to claim 2, **characterized in that**, in step (a), said second layer (30) of nickel is deposited by electrolysis.

4. The method according to any one of claims 1 to 3, **characterized in that** said substrate (10) is a superalloy.

5. The method according to claim 4, **characterized in that** said superalloy is a nickel-based superalloy.

6. The method according to any one of claims 1 to 5, **characterized in that** before the deposition of said layer (23) in step (a), said surface (11) is prepared.
